# EUROPEAN PATENT APPLICATION

(11) **EP 4 564 606 A1**
(43) Date of publication of application: **04.06.2025**
(21) Application number: 23212526.0
(22) Date of filing: 28.11.2023
(51) Int. Cl.: H01Q 9/04

(54) **MULTIBAND PATCH ANTENNA AND METHOD FOR MANUFACTURING A MULTIBAND PATCH ANTENNA**

(71) Applicant: u-blox AG, 8800 Thalwil (CH)
(72) Inventor: Gergis, Anthony, 02600 Espoo (FI); Saarnimo, Timo, 02600 Espoo (FI)
(74) Representative: Epping - Hermann - Fischer

(57) **Abstract**

In one embodiment a multiband patch antenna comprises a first antenna (Al) with a first through-hole-feed (Fl), a second antenna (A2) with a second through-hole-feed (F2), a first pin (P1), an antenna printed circuit board, PCB, (PCB1) comprising a first antenna feed point (AFP1), an interposer PCB (PCB2), and a main PCB (PCB3). The first antenna (Al) and second antenna (A2) are mounted on top of each other and on top of the antenna PCB (PCB1), each of the first and the second antenna (Al, A2) having an electrical connection with the antenna PCB (PCB1). The first pin (Pl) is mechanically and electrically connected to at least one of the first and the second through-hole feeds (Fl, F2) and to the first antenna feed point (AFP1). The interposer PCB (PCB2) is mounted between the antenna PCB (PCB1) and the main PCB (PCB3) and is mechanically and electrically connected to the antenna PCB (PCB1) and to the main PCB (PCB3).

## Description

### Technical field

The present disclosure relates to the field of wireless communication, especially to antennas for receiving radio frequency signals. Specifically, the disclosure is directed to a multiband patch antenna and a method for manufacturing a multiband patch antenna.

### Background

A patch antenna is a flat directional antenna consisting of a metallic surface mounted on an insulating substrate. The surface usually has a rectangular or circular shape and a length of approximately half the wavelength of the desired frequency. The patch antenna is shielded by a metal surface on the other side of the substrate, which serves as a ground plane. The patch antenna can be connected to a coaxial cable or a microstrip line in various ways. A patch antenna is easy to design and inexpensive to manufacture. It further has a small thickness and can be attached to various surfaces. It can have different polarization types, such as linear, circular or elliptical. Patch antennas may be used in various devices, such as terminals or user equipment in wireless communication, e.g. mobile radio, wireless local area network, WLAN, or Bluetooth, or in global navigation satellite system, GNSS, receivers. For all these application scenarios compact low-cost antennas are particularly desirable.

Patch antennas, however, have a limited beam width and a narrow bandwidth, which makes them unsuitable for wide area coverage. This means that they can only receive and transmit signals in a specific direction and usually are optimized for a specific frequency or a narrow frequency range. If the frequency changes, the performance of the antenna may decrease or the impedance matching may be lost. Therefore, in order to cover different frequency ranges or bands, one patch antenna has to be provided for each band resulting in a larger footprint.

In other known implementations, a chip-based antenna is employed. A chip-based antenna is a type of antenna that consists of a small chip made of a dielectric material that has a metallic structure on its surface or inside. The metallic structure forms an electrical resonator that can receive or transmit electromagnetic waves. Chip-based antennas are compact, lightweight and easy to integrate, but they also have some disadvantages, such as low bandwidth, high sensitivity to the environment and low radiation efficiency. A chip-based antenna can have different shapes and sizes depending on the desired frequency range, impedance matching, polarization and radiation pattern. However, chip-based antennas have a higher height compared with patch antennas, which renders chip-based antennas unsuitable for appliances with restrictions in size.

GNSS enabled devices use antennas that can receive electromagnetic waves from GNSS satellites. The antennas should have a high sensitivity, good impedance matching and a small size. Often it is required that signals in different frequency bands can be received. Also, those devices have to pass certain drop tests and/or structural integrity tests for ensuring product quality. Antennas implemented in such devices should therefore be enabled to resist mechanical shock. Moreover, signals received via the antennas have to be pre-processed for further handling within the receiver, e.g. the GNSS receiver. Known solutions realize this functionality in a separate component, thereby occupying more space, which appears counterproductive.

An objective could therefore be seen in providing an antenna for more than one RF frequency band which overcomes one or more shortcomings of the prior art in terms of footprint and mechanical stability.

The objective is achieved by the subject-matter of the independent claims. Embodiments and developments are defined in the dependent claims.

The definitions provided above also apply to the following description unless stated otherwise.

### Summary

In one embodiment a multiband patch antenna comprises a first antenna, a second antenna, a first pin, an antenna printed circuit board, PCB, an interposer PCB and a main PCB. The first antenna comprises a first through-hole feed. The second antenna comprises a second through-hole feed. The antenna PCB comprises a first antenna feed point. The first antenna is mounted on top of the second antenna which is mounted on top of the antenna PCB. The first antenna and the second antenna both have an electrical connection with the antenna PCB. The first pin is mechanically and electrically connected to at least one of the first and the second through-hole feeds and to the first antenna feed point of the antenna PCB. The interposer PCB is mounted between the antenna PCB and the main PCB and is connected mechanically and electrically to the antenna PCB and to the main PCB.

The multiband patch antenna specified herein is based on two antennas which are stacked on top of each other and three PCBs which are arranged in a sandwich-like structure beneath the two stacked antennas. The resulting multiband patch antenna is able to receive signals in at least two different frequency bands. Furthermore, by way of the stacked arrangement, a compact form factor is achieved, which increases the mechanical stability and reliability at the same time.

Each of the three PCBs can be realized as a single layer or as a multilayer PCB. The first antenna feed point can be realized as a through-hole via or as a feed-through.

The specified multiband patch antenna is consequently well suited for implementation as part of a receiver in mobile and wireless devices, especially for realizing GNSS functionality in the receiver.

According to a development, respective sizes of the antenna PCB, the interposer PCB and the main PCB are matched.

This increases the mechanical stability and supports the compact form factor of the multiband patch antenna.

In a development, the main PCB comprises electronic components for handling signals received by the first and/or the second antenna. A height of the interposer PCB is higher than a height of a highest electronic component of the components mounted on the main PCB.

The electronic components mounted on the main PCB may realize the functions of a classic antenna frontend, as known to the skilled person. These tasks basically comprise filtering and amplifying the incoming radio frequency signals. Suitable power circuits may also be part of these components on the main PCB. The height of the interposer PCB is adapted such that the electronic components of the main PCB are covered by the antenna PCB in the final arrangement of the multiband patch antenna, wherein the antenna PCB forms a lid, so to say. This hides the detailed structure of the antenna or RF frontend realized by the components on the main PCB and provides additional protection for said components.

In a development, the multiband patch antenna comprises a first and a second gluing connection. The first gluing connection is arranged between the antenna PCB and the interposer PCB, while the second gluing connection is arranged between the interposer PCB and the main PCB.

The first and the second gluing connection realize the mechanical connections within the stack of the three PCBs. Each gluing connection, which may also be referred to as an adhesive bond, can be realized by a number of glue dots which are applied to one of the surfaces of the PCBs involved in said gluing connection. In this way, a low cost solution for achieving high mechanical robustness of the resulting multiband patch antenna is achieved. Alternatively or in addition to the gluing connections, the surfaces of the interposer PCB and the main PCB, and/or of the interposer PCB and the antenna PCB may comprise oppositely formed or mirror-inverted surface structures, e.g. steps, recesses, ridges and other forms of tight fits, that engage with each other on contact and are configured to enhance and/or provide a stable mechanical connection between the on top of each other disposed PCBs.

In a development, the first and the second antenna are each realized as a circularly polarized patch antenna. The first antenna is configured to operate in one GNSS frequency band, specifically one of L1, L2 or L5 band. The second antenna is configured to operate in a different GNSS frequency band than the first antenna, specifically in a different one of L1, L2 or L5 band.

Herein, L1, L2 and L5 bands are merely mentioned as examples for important and most widespread GNSS frequency bands. Other equivalent frequency bands such as the E6 or E5 band, as well as the G1 and G2 bands or the S band may also represent the bands in which the first or the second antenna is configured to operate. Thereby, multiband and multi-GNSS functionality is realized by the multiband patch antenna as specified.

In a development, the interposer PCB has a recess having a center which coincides with the center of the interposer PCB. A size of the recess is adapted to accommodate all electronic components of the main PCB.

Consequently the interposer PCB has a cutout which results in a frame-like shape. The frame-like interposer PCB therefore forms a kind of rectangular ring which surrounds the components of the main PCB in the final stack of the multiband patch antenna.

In a development, the first antenna feed point of the antenna PCB is located at or near a center of the antenna PCB.

This centred arrangement further increases the mechanical stability.

In a development, the first pin reaches through the first through-hole feed of the first antenna and the second through-hole feed of the second antenna, such that the first and the second antenna are connected to each other mechanically and electrically. The first pin is soldered to the first antenna feed point of the antenna PCB on a surface of said antenna PCB which faces the main PCB. The main PCB has an area which is free from any electronic component. This area is arranged in correspondence with the first antenna feed point of the antenna PCB.

In this embodiment the first pin mechanically fixes the first and the second antenna to the antenna PCB and provides the electrical connection of the first and/or the second antenna to the first antenna feed point. The multiband patch antenna is therefore well prepared to withstand drop tests and/or structural integrity tests. The area beneath the soldering point which connects the first pin to the first antenna feed point on the main PCB is not covered by any electronic component.

In a development, the antenna PCB comprises a first antenna radio frequency, RF, pad having an electrical connection to the first antenna feed point. The first antenna RF pad is arranged on a surface of the antenna PCB which faces the main PCB and extends to an edge of the antenna PCB.

Favourably, the surface of the antenna PCB facing the main PCB, i.e. the bottom surface of the antenna PCB, is equipped with a conducting layer and is configured to carry ground potential, except for the first antenna RF pad on the lower surface. The grounded conducting layer may function as a counterbalance, i.e. as part, of the first and/or second antenna as well as an electromagnetic protection based on Faraday principle for the components on the main PCB. Signals received by the first and/or the second antenna are propagated by the first pin and the first antenna feed point towards the first antenna RF pad.

In a development, the interposer PCB comprises a first interposer RF pad located on one of its edges. A position of the first interposer RF pad corresponds with the position to the first antenna RF pad of the antenna PCB. The first interposer RF pad comprises a via extending from the first surface of the interposer PCB, which faces the antenna PCB, to a second surface of the interposer PCB, which faces the main PCB.

The via is an electrical connection between the first and the second surface of the interposer PCB. The first and the second surface are both realized as metal layers. The via may be provided by drilling a hole through the interposer PCB and plating it with metal, for example copper, as known by the skilled person. Consequently, by means of the via, a signal may be propagated from the first to the second surface. By arranging the interposer PCB in relation to the antenna PCB such that the first antenna RF pad directly lies above the first interposer RF pad, the signal received by the first and/or second antenna can be propagated to the second surface of the interposer PCB.

In a development, the main PCB comprises a first main RF pad located on one of its edges. A position of the first main RF pad corresponds with the position of the first interposer RF pad of the interposer PCB.

By means of the first main RF pad a received RF signal, for example a GNSS signal, is propagated from the interposer PCB towards the electronic components of the main PCB.

In an alternative development, the multiband patch antenna further comprises a second pin. The second antenna comprises a third through-hole feed and the antenna PCB comprises a second antenna feed point. The first pin reaches through the first through-hole feed of the first antenna, the second through-hole feed of the second antenna and is soldered to the first antenna feed point of the antenna PCB. The first pin is electrically and mechanically connected to the first through-hole feed. The second pin reaches through the third through-hole feed of the second antenna and is soldered to the second antenna feed point of the antenna PCB. The second pin is electrically and mechanically connected to the third through-hole feed.

This embodiment of the multiband patch antenna relies on two pins, namely the first and the second pin. Signals received by the first and/or the second antenna are separately provided by means of the first and the second antenna feed point to the antenna PCB. Mechanical stability may be further increased with this two-pin solution, while achieving the same small footprint.

According to a development, the antenna PCB comprises a first antenna RF pad and a second antenna RF pad. The first antenna RF pad extends to an edge of the antenna PCB and is electrically connected to the first antenna feed point. The second antenna RF pad extends to an edge of the antenna PCB and is electrically connected to the second antenna feed point. The first antenna RF pad and the second antenna RF pad are arranged on a surface of the antenna PCB which faces the main PCB.

Signals received by the first antenna are propagated via the first antenna feed point to the first antenna RF pad. Signals received by the second antenna are passed via the second antenna feed point to the second antenna RF pad. First and second antenna RF pads are both located on an edge of the antenna PCB, for example on different edges or on the same edge of the antenna PCB.

In a development, the interposer PCB comprises a first interposer RF pad and a second interposer RF pad, each located on one of the edges of the interposer PCB. A position of the first interposer RF pad corresponds with the position of the first antenna RF pad of the antenna PCB. A position of the second interposer RF pad corresponds with the position of the second antenna RF pad of the antenna PCB. Each of the first and the second interposer RF pads comprises a via extending from a first surface of the interposer PCB, which faces the antenna PCB, to a second surface of the interposer PCB, which faces the main PCB. The main PCB comprises a first main RF pad and a second main RF pad, each of which is located on one of the edges of the main PCB. A position of the first main RF pad corresponds with the position of the first interposer RF pad of the interposer PCB and a position of the second main RF pad corresponds with the position of the second interposer RF pad of the interposer PCB.

Signals received by the first antenna are passed via the first antenna RF pad and the first interposer RF pad to the first main RF pad and to the electronic components of the main PCB. Signals received by the second antenna are passed via the second antenna RF pad and the second interposer RF pad to the second main RF pad and finally to the electronic components of the main PCB for further processing. The electrical connections between the different RF pads of the three PCBs, namely the main PCB, the interposer PCB and the antenna PCB, are realized for instance by direct mechanical contact of the involved RF pads or by soldering the corresponding RF pads.

In a development, the interposer PCB comprises a plurality of vias placed along its edges. Said plurality of vias forms a part of a Faraday cage.

Each of these vias has a same potential, for example ground. A surface of the antenna PCB which faces the main PCB also carries ground potential. Likewise, a surface of the main PCB which faces the interposer PCB also carries ground potential. A Faraday cage is consequently formed by the plurality of vias along the edges of the interposer PCB, the surface of the main PCB and the surface of the antenna PCB. Thereby electromagnetic fields originating from radio waves or static electric charges occurring at the surroundings of the multiband patch antenna are blocked from the electronic components of the main PCB. The plurality of vias in combination with the bottom surface of the antenna PCB create a conductive shell around these electronic components and the effects of external fields are cancelled out inside this cage. Unwanted electromagnetic interference is prohibited.

In one embodiment a method for manufacturing a multiband patch antenna comprises the following steps:
Receiving an antenna component having an antenna PCB, a second antenna and a first antenna mounted on top of each other in a stacked arrangement,
providing an interposer PCB,
providing a main PCB,
populating the main PCB and applying solder paste to the main PCB,
applying at least two glue dots to a surface of the interposer PCB,
providing a base component by soldering and gluing the interposer PCB on top of the main PCB,
applying solder paste to the interposer PCB of the base component,
applying at least two glue dots to the antenna component, providing the multiband patch antenna by soldering and gluing the base component to the antenna component.

The multiband patch antenna manufactured by the proposed method has a small form factor, is able to receive and process signals in at least two different frequency ranges or bands and has advanced mechanical stability.

Within the antenna component one or two pins may be used for electrical and/or mechanical connection between first and second antenna and antenna PCB.

Populating the main PCB comprises mounting the electronic components to the main PCB.

The way of manufacturing the multiband patch antenna is a low cost process and provides the inexpensive multiband patch antenna. In the antenna component, the first and the second antenna are soldered on the antenna PCB. The interposer PCB may be provided in the form of a tape and reel for efficient and precise mounting. To speed up the procedure, some of the steps may be processed concurrently, for instance applying solder paste to the main PCB and applying glue dots to the interposer PCB, or applying solder paste to the interposer PCB and applying glue dots to the antenna component. By applying glue dots and subsequently gluing two components together, for example by heating, the gluing connections as defined above are achieved.

Even though it has been found that the above-described method is the most efficient way of manufacturing the multiband patch antenna, some of the steps may be realized in an alternative way. For example, glue dots may be applied to both surfaces of the interposer PCB in addition to or instead of applying glue dots to the antenna component.

### Brief description of the drawings

The text below explains the proposed solution in detail using exemplary embodiments with reference to the drawings. Components and elements that are functionally identical or have an identical effect bear identical reference numbers. Insofar as parts or components correspond to one another in their function, a description of them will not be repeated in each of the following figures. Therein,
Figures 1A to 1E each show an exemplary embodiment of a multiband patch antenna as proposed or parts thereof,
Figures 2A and 2B each show an exemplary embodiment of an antenna component for use in the proposed multiband patch antenna,
Figures 3A and 3B each show an exemplary embodiment of an antenna PCB as proposed,
Figures 4A and 4B, 5B and 5B, and 6 each show an exemplary embodiment of an interposer PCB as proposed, and
Figure 7 shows an exemplary flowchart of a method as proposed.

### Detailed description

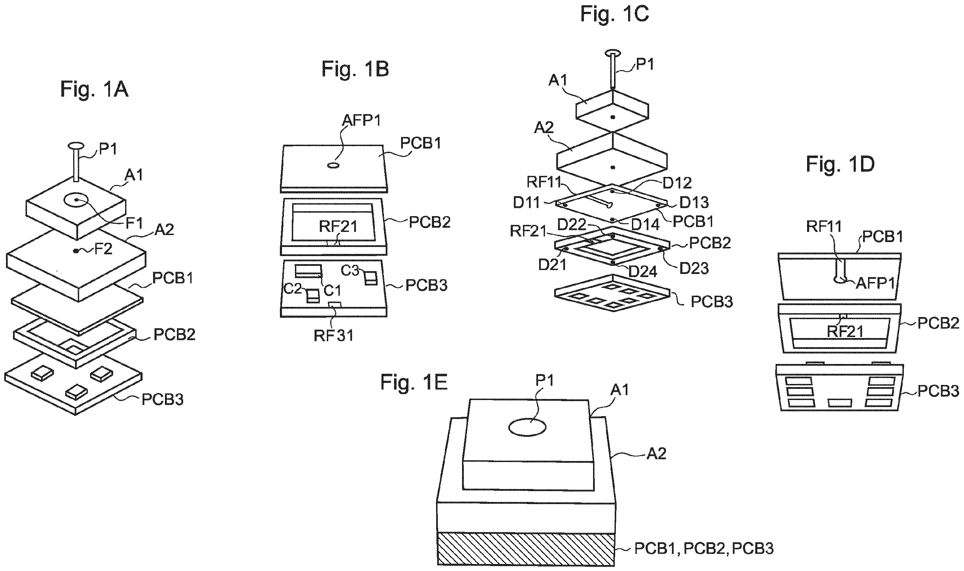

Figures 1A to 1D each show an exemplary embodiment of a multiband patch antenna as proposed or parts thereof from different angles.

Figures 1A and 1C each show an exemplary embodiment of the multiband patch antenna as proposed in isometric exploded views. In each case, the multiband patch antenna is depicted in a detached form such that all the components can be discerned. Figure 1A shows an isometric view from above. The multiband patch antenna comprises a first pin P1, a first antenna A1 having a first through-hole feed F1, a second antenna A2 having a second through-hole feed F2, an antenna PCB PCB1, an interposer PCB PCB2 and a main PCB PCB3.

The first and the second antenna A1, A2 are each realized as a circularly polarized patch antenna, which has a rectangular shape in this example. Other shapes are possible for antennas A1 and A2. The antennas are configured to operate in different RF frequency bands. For instance, the first antenna A1 is configured for the GNSS frequency band L1, while the second antenna A2 is configured for the GNSS frequency band L5. First and second through-hole feeds F1 and F2 are arranged at or near the center of the respective first or second antenna A1 or A2. When the multiband patch antenna is mounted, the first pin reaches through the first through-hole feed F1, the second through-hole feed F2, until the first antenna feed point AFP1 of the antenna PCB PCB1 and forms a sort of a middle pin. The first pin P1 is soldered to the first antenna feed point AFP1 on a surface of the antenna PCB PCB1 which faces towards the main PCB PCB3. A potential at the upper surface of each PCB is ground potential.

As shown in Figure 1A, first and second antenna A1, A2 may have different sizes. For reasons of mechanical robustness, the first antenna A1, which has a smaller size, is mounted on top of the second antenna A2. In this single pin embodiment of the multiband patch antenna having exactly one pin, namely the first pin P1, said pin mechanically and electrically connects first and second antennas A1 and A2 to the antenna PCB PCB1. A height of the interposer PCB is configured to be higher than the highest of the electronic components placed on the main PCB PCB3. The interposer PCB PCB2 has a central recess resulting in a frame-like form of said PCB which, when mounted on top of the main PCB PCB3, encloses the electronic components.

Figure 1B shows the three PCBs of Figure 1A in more detail. In this figure, the first antenna feed point AFP1 can be discerned on the antenna PCB PCB1. Furthermore, the first interposer RF pad RF21 on the interposer PCB PCB2 is shown. Said pad RF21 is located in this example on the front edge of the interposer PCB PCB2. It comprises a via extending from the upper surface to the lower surface of the interposer PCB PCB2, thereby electrically connecting both surfaces of pad RF21. On the main PCB PCB3 electronic components C1, C2 and C3 are shown, as well as a first main RF pad RF31. A position of the first main RF pad RF31 corresponds with the position of the first interposer RF pad RF21 such that when the three PCBs, PCB1, PCB2 and PCB3, are mounted and fixed to each other, an electrical connection between those pads is realized.

Figure 1C shows the multiband patch antenna of Figure 1A in an exploded isometric view from below. The antenna is turned 90° to the left with respect to Figure 1A. In this view, a first antenna RF pad RF11 becomes apparent, which electrically connects the first antenna feed point AFP1 on the antenna PCB PCB1 and extends towards the front left edge of the antenna PCB PCB1. Furthermore, four glue dots, D11, D12, D13 and D14, are shown which are arranged near the corners of the antenna PCB PCB1 on the lower surface of said PCB which faces towards the interposer PCB PCB2.

On the interposer PCB PCB2, four glue dots D21, D22, D23 and D24 are provided which are arranged on the lower surface of the interposer PCB PCB2 facing the main PCB PCB3. Positions of each of D21 to D24 of the interposer PCB PCB2 are roughly aligned with positions of the glue dots D11 to D14 of the antenna PCB PCB1 for optimal mechanical robustness.

This exemplary embodiment uses four glue dots on the lower surface of the antenna PCB PCB1 and four glue dots on the lower surface of the interposer PCB PCB2, however a number of two glue dots is also sufficient for realizing a stable multiband patch antenna which does not detach in drop and/or structural integrity tests. Positioning the glue dots in the corners of involved PCBs may provide optimum results in terms of stability.

Figure 1D shows the three PCBs of Figure 1C in more detail. It can be discerned that a position of the first interposer RF pad RF21 is aligned with a position of the first antenna RF pad RF11.

Figure 1E shows an exemplary embodiment of the multiband patch antenna as proposed in assembled form. The first antenna A1 is mounted on top of the second antenna A2, both of which are fixed together by the first pin P1, which is soldered to the antenna PCB PCB1. This provides the antenna component. The antenna PCB PCB1, the interposer PCB PCB2 and the main PCB PCB3 are arranged in a stack, fixed to each other by suitable gluing connections and electrically connected by suitable solder connections or tight contact. It can be discerned that the resulting assembled multiband patch antenna has a small form factor and high mechanical reliability.

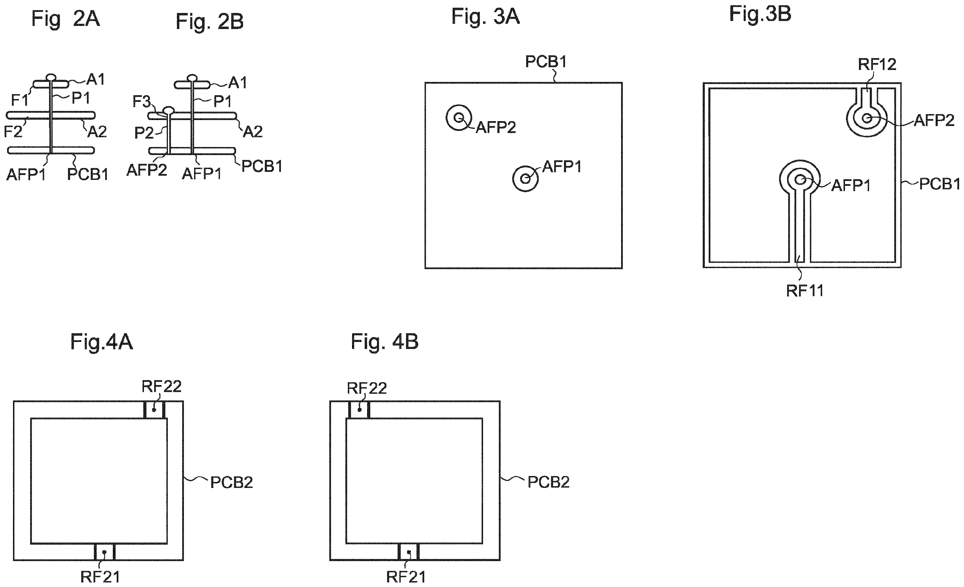

Figure 2A shows an exemplary embodiment of an antenna component for use in the proposed multiband patch antenna in a cross-sectional view. The first pin P1 reaches through the first antenna's A1 through-hole feed F1, the second antenna's A2 through-hole feed F2 to the first antenna feed point AFP1 on the antenna PCB PCB1. The first pin P1 realizes the electrical and the mechanical connection between first and second antennas A1, A2 and the antenna PCB PCB1.

Figure 2B shows another exemplary embodiment of an antenna component to be used in the proposed multiband patch antenna in a cross-sectional view. This embodiment employs two pins, namely the first pin P1 and a second pin P2. As in Figure 2A, the first pin P1 reaches through through-hole feeds F1 and F2 of the first and the second antenna A1 and A2 and is soldered to the first antenna feed point AFP1 on the bottom layer of the antenna PCB PCB1. In contrast to Figure 2A, the first pin is only mechanically connected with the second antenna A2, not electrically. The electrical connection between the second antenna A2 and the antenna PCB PCB1 is realized by the second pin P2, which reaches through the third through-hole feed F3 on the second antenna A2 to the second antenna feed point AFP2 on the antenna PCB PCB1.

Figure 3A shows an exemplary embodiment of the antenna PCB for use in the two-pin solution of Figure 2B. The upper surface of said PCB is shown which faces the second antenna. The first antenna feed point AFP1 is arranged at or near the middle of the antenna PCB PCB1, while the second antenna feed point AFP2 is located apart from the first antenna feed point AFP1 but still close to the center. Apart from the two feed points AFP1 and AFP2, the remaining upper surface is clear from any conducting layers or connections.

Figure 3B shows the lower or bottom side of the antenna PCB of Figure 3A, the surface facing towards the interposer and the main PCB. Said lower surface has the first antenna RF pad RF11 and a second antenna RF pad RF12 which is realized in a similar fashion as RF11. Each of the RF pads RF11, RF12 connects one antenna feed point AFP1, AFP2, respectively. In this example, the RF pads RF11 and RF12 are arranged on different edges of the antenna PCB PCB1. The RF pads RF11, RF12 and the antenna feed point AFP1, AFP2 are each isolated from and surrounded by a conducting layer having a different potential, for instance ground. This conducting layer will form a part of the Faraday cage, when in contact with the corresponding vias of the interposer PCB. In another exemplary embodiment, not shown, the ground conducting layer may be arranged on the top side of the antenna PCB, instead of the bottom side, electrically isolated from the antenna feed points AFP1, AFP2. In that case, the antenna PCB comprises additional vias identically arranged to the vias of the interposer PCB in order to provide a plurality of electrical contacts from the ground layer on the top side to the bottom side of the antenna PCB. Compared to the solution of the conducting layer on the bottom side, the area of the top side ground conducting layer would be larger due to the missing RF pads RF11, RF12.

Figure 4A shows an upper surface of an interposer PCB for the two-pin solution of Figure 2B. Said interposer PCB is to be used with the antenna PCB of Figures 3A and B. The upper surface facing towards the antenna PCB comprises the first interposer RF pad RF21 and a second interposer RF pad RF22. Both pads RF21 and RF22 comprise a via from the upper to the lower surface of the interposer PCB2, which is shown in Figure 4B. The position of the first interposer RF pad RF21 is aligned with the position of the first antenna RF pad RF11, while the position of the second interposer RF pad RF22 is aligned with the position of the second antenna RF pad RF12.

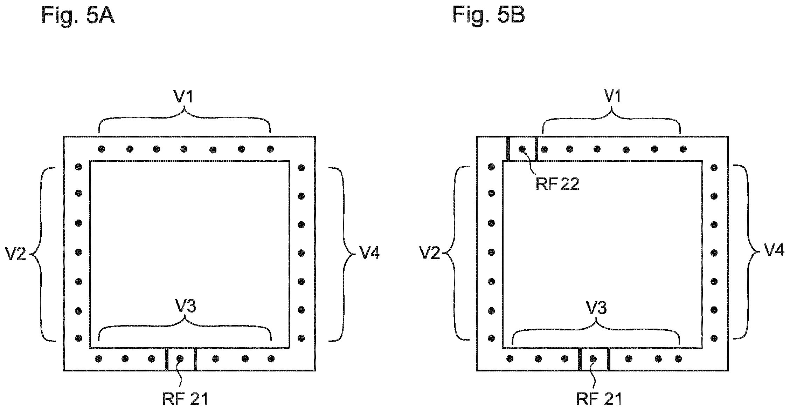

Figure 5A shows an exemplary embodiment of an interposer PCB with a plurality of vias forming part of a Faraday cage as proposed. This interposer PCB PCB 2 may be used in the one-pin solution of Figures 1A to E, for example. Besides the first interposer RF pad RF21, the interposer PCB PCB 2 comprises the plurality of vias V1, V2, V3 and V4. The vias are located along the edges of the interposer PCB PCB2, leaving the corners free.

Figure 5B shows another exemplary embodiment of the interposer PCB with vias as proposed for the two-pin solution of Figure 2A, for example. The plurality of vias V1, V2, V3 and V4 is arranged along the four edges of the interposer PCB, but not in its corners, to increase structural stability.

In Figures 5A and 5B each via of the plurality of vias V1 to V4 is realized as a via as known to those skilled in the art.

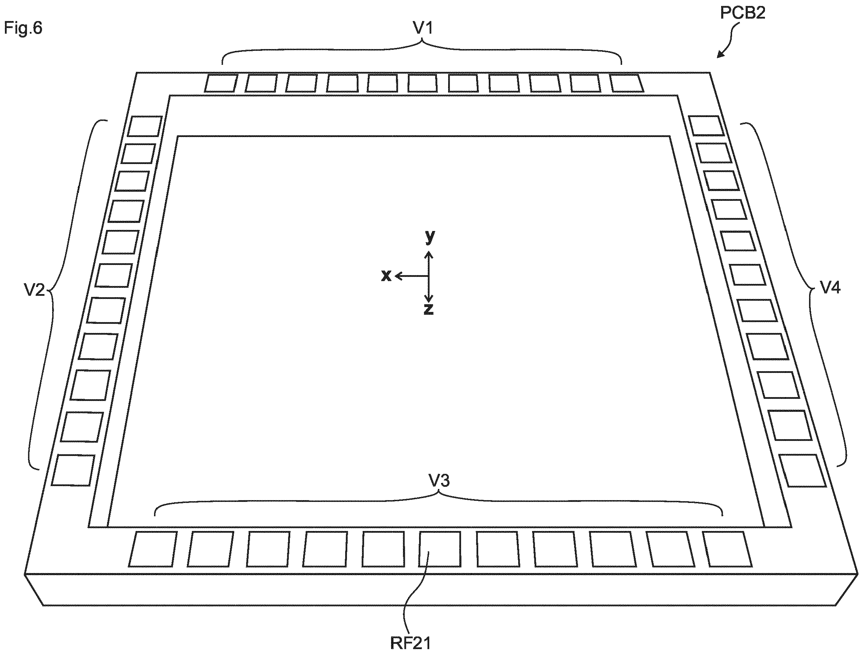

Figure 6 shows another embodiment of the interposer PCB with the plurality of vias as proposed in a three-dimensional view. Said embodiment is suitable for the single pin embodiment as shown in Figures 1A to E. In this example each of the vias of the plurality of vias V1 to V4 is realized as a filled via with a conducting pad on both surfaces of the interposer PCB PCB2.

As already described, the plurality of vias V1 to V4, together with conductive surfaces of the antenna PCB PCB1 and the main PCB PCB3, form a Faraday cage which protects the electronic components mounted on the main PCB against electrostatic discharge or radio waves from the outside.

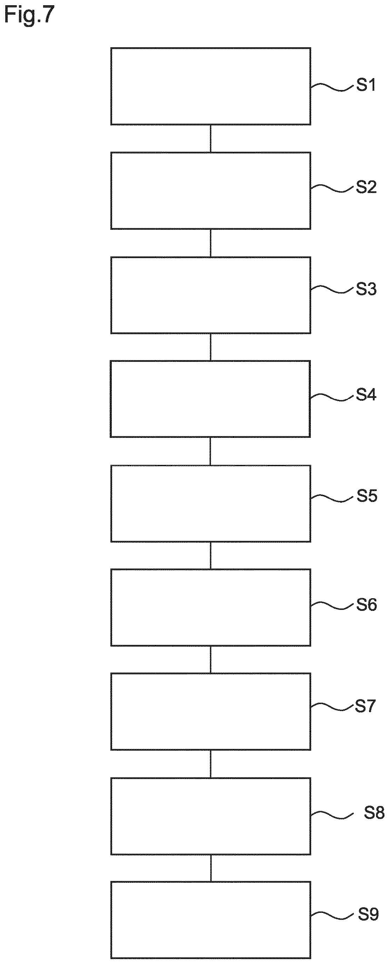

Figure 7 shows an exemplary flowchart of a method for manufacturing a multiband patch antenna as proposed. The method for manufacturing the multiband patch antenna comprising the following steps:
S1: Receiving an antenna component having an antenna PCB, a second antenna and a first antenna mounted on top of each other in a stacked arrangement,
S2: Providing an interposer PCB,
S3: Providing a main PCB,
S4: Populating the main PCB and applying solder paste to the main PCB,
S5: Applying at least two glue dots to a surface of the interposer PCB,
S6: Providing a base component by soldering and gluing the interposer PCB on top of the main PCB,
S7: Applying solder paste to the interposer PCB of the base component,
S8: Applying at least two glue dots to the antenna component, and
S9: Providing the multiband patch antenna by soldering and gluing the base component to the antenna component.

The method maybe employed to manufacture the multiband patch antenna as specified herein and as shown in the above-described figures.

It will be appreciated that the invention is not limited to the disclosed embodiments and to what has been particularly shown and described hereinabove. Rather, features recited in separate dependent claims or in the description may advantageously be combined. The described multiband patch antenna may also be advantageously used in other than satellite based navigation systems, and also in other applications than navigation systems. Furthermore, the scope of the invention includes those variations and modifications which will be apparent to those skilled in the art and fall within the scope of the appended claims. The term "comprising" used in the claims or in the description does not exclude other elements or steps of a corresponding feature or procedure. In the case that the terms "a" or "an" are used in conjunction with features, they do not exclude a plurality of such features. Moreover, any reference signs in the claims should not be construed as limiting the scope.

### Reference list

- PCB1, PCB2, PCB3: antenna, interposer, main PCB
- AFP1, APF2: antenna feed point
- F1, F2, F3: through-hole-feed
- P1, P2: pin
- RF11, RF12, RF21, RF22: RF pad
- A1, A2: antenna
- D11, D12, D13, D14: glue dot
- D21, D22, D23, D24: glue dot
- C1, C2, C3: electronic component
- V1, V2, V3, V4: vias
- S1, S2, ..., S9: step

## Claims

1. A multiband patch antenna comprising
a first antenna (A1) comprising a first through-hole-feed (F1),
a second antenna (A2) comprising a second through-hole-feed (F2),
a first pin (P1),
an antenna printed circuit board, PCB, (PCB1) comprising a first antenna feed point (AFP1),
an interposer PCB (PCB2), and
a main PCB (PCB3),
wherein the first antenna (A1) and the second antenna (A2) are mounted on top of each other and on top of the antenna PCB (PCB1), each of the first and the second antenna (A1, A2) having an electrical connection with the antenna PCB (PCB1), wherein the first pin (P1) is mechanically and electrically connected to at least one of the first and the second through-hole feeds (F1, F2) and to the first antenna feed point (AFP1) of the antenna PCB (PCB1), and
wherein the interposer PCB (PCB2) is mounted between the antenna PCB (PCB1) and the main PCB (PCB3) and is mechanically and electrically connected to the antenna PCB (PCB1) and to the main PCB (PCB3).

2. The multiband patch antenna according to the previous claim,
wherein respective sizes of the antenna PCB (PCB1), the interposer PCB (PCB2) and the main PCB (PCB3) are matched, and/or
wherein the main PCB (PCB3) comprises various electronic components (C1, C2, C3, C4) for handling signals received via the first and/or the second antenna (A1, A2), and
wherein a height of the interposer PCB (PCB2) is higher than a height of a highest electronic component of the components (C1, C2, C3, C4) of the main PCB (PCB3).

3. The multiband patch antenna according to any of the previous claims,
further comprising a first gluing connection between the antenna PCB (PCB1) and the interposer PCB (PCB2) and a second gluing connection between the interposer PCB (PCB2) and the main PCB (PCB3).

4. The multiband patch antenna according to any of the previous claims,
wherein the first antenna (A1) and the second antenna (A2) each is realized as a circularly polarized patch antenna, wherein the first antenna (A1) is configured to operate in one Global Navigation Satellite System, GNSS, frequency band, specifically one of L1, L2 or L5 band, and
wherein the second antenna (A2) is configured to operate in a different GNSS frequency band than the first antenna (A1), specifically in a different one of L1, L2 or L5 band.

5. The multiband patch antenna according to any of the previous claims,
wherein the interposer PCB (PCB2) has a recess having a center which coincides with a center of the interposer PCB (PCB2) and wherein a size of the recess is adapted to accommodate all electronic components (C1, C2, C3, C4) of the main PCB (PCB3).

6. The multiband patch antenna according to any of the previous claims,
wherein the first antenna feed point (AFP1) of the antenna PCB (PCB1) is located at or near a center of the antenna PCB (PCB1) .

7. The multiband patch antenna according to any of the previous claims,
wherein the first pin (P1) reaches through the first through-hole feed (F1) of the first antenna (A1) and the second through-hole feed (F2) of the second antenna (A2), such that the first and the second antenna (A1, A2) are connected to each other mechanically and electrically,
wherein the first pin (P1) is soldered to the first antenna feed point (AFP1) of the antenna PCB (PCB1) on a surface of the antenna PCB (PCB1) which faces the main PCB (PCB3), and wherein the main PCB (PCB3) has an area, which is free from any electronic component, said area being arranged in correspondence with the first antenna feed point (AFP1) of the antenna PCB (PCB1).

8. The multiband patch antenna according to any of the previous claims,
wherein the antenna PCB (PCB1) comprises a first antenna radio-frequency, RF, pad (RF11) having an electrical connection to the first antenna feed point (AFP1),
wherein the first antenna RF pad (RF11) is arranged on a surface of the antenna PCB (PCB1) which faces the main PCB (PCB3) and extends to an edge of the antenna PCB (PCB1).

9. The multiband patch antenna according to the previous claim,
wherein the interposer PCB (PCB2) comprises a first interposer RF pad (RF21) located on one of its edges, wherein a position of the first interposer RF pad (RF21) corresponds with a position of the first antenna RF pad (RF11) of the antenna PCB (PCB1), and wherein the first interposer RF pad (RF21) comprises a via extending from a first surface of the interposer PCB (PCB2), which faces the antenna PCB (PCB1), to a second surface of the interposer PCB (PCB2), which faces the main PCB (PCB3).

10. The multiband patch antenna according to the previous claim,
wherein the main PCB (PCB3) comprises a first main RF pad (RF31) located on one of its edges, wherein a position of the first main RF pad (RF31) corresponds with a position of the first interposer RF pad (RF21) of the interposer PCB (PCB2).

11. The multiband patch antenna according to any of claims 1 to 6,
further comprising a second pin (P2),
wherein the second antenna comprises a third through-hole feed (F3) and the antenna PCB (PCB1) comprises a second antenna feed point (AFP2),
wherein the first pin (P1) reaches through the first through-hole feed (F1) of the first antenna (A1), the second through-hole feed (F2) of the second antenna (A2) and is soldered to the first antenna feed point (AFP1) of the antenna PCB (PCB1), wherein the first pin (P1) is electrically and mechanically connected to the first through-hole feed (F1), wherein the second pin (P2) reaches through the third through-hole feed (F3) of the second antenna (A2) and is soldered to the second antenna feed point (AFP2) of the antenna PCB (PCB1), wherein the second pin (P2) is electrically and mechanically connected to the third through-hole feed (F3).

12. The multiband patch antenna according to the previous claim,
wherein the antenna PCB (PCB1) comprises a first antenna RF pad (RF11) and a second antenna RF pad (RF12),
wherein the first antenna RF pad (RF11) extends to an edge of the antenna PCB (PCB1) and is electrically connected to the first antenna feed point (AFP1),
wherein the second antenna RF pad (RF11) extends to an edge of the antenna PCB (PCB1) and is electrically connected to the second antenna feed point (AFP2), and
wherein the first antenna RF pad (RF11) and the second antenna RF pad (RF12) are arranged on a surface of the antenna PCB (PCB1) which faces the main PCB (PCB3).

13. The multiband patch antenna according to the previous claim,
wherein the interposer PCB (PCB2) comprises a first interposer RF pad (RF21) and a second interposer RF pad (RF22) each located on one of the edges of the interposer PCB (PCB2) ,
wherein a position of the first interposer RF pad (RF21) corresponds with a position of the first antenna RF pad (RF11) of the antenna PCB (PCB1),
wherein a position of the second interposer RF pad (RF22) corresponds with a position of the second antenna RF pad (RF12) of the antenna PCB (PCB1),
wherein each of the first interposer RF pad (RF21) and the second interposer RF pad (RF21) comprises a via extending from a first surface of the interposer PCB (PCB2), which faces the antenna PCB (PCB1), to a second surface of the interposer PCB (PCB2), which faces the main PCB (PCB3),
and wherein the main PCB (PCB3) comprises a first main RF pad (RF31) and a second main RF pad (RF32), each located on one of the edges of the main PCB (PCB3), wherein a position of the first main RF pad (RF31) corresponds with a position of the first interposer RF pad (RF21) of the interposer PCB (PCB2) and a position of the second main RF pad (RF32) corresponds with a position of the second interposer RF pad (RF22) of the interposer PCB (PCB2).

14. The multiband patch antenna according to any of the previous claims,
wherein the interposer PCB (PCB2) comprises a plurality of vias (V1, V2, V3, V4) placed along its edges, said plurality of vias forming a part of a Faraday cage.

15. A method for manufacturing a multiband patch antenna comprising the following steps:
Receiving (S1) an antenna component having an antenna printed circuit board, PCB, (PCB1), a second antenna (A2) and a first antenna (A1) mounted on top of each other in a stacked arrangement,
Providing (S2) an interposer PCB (PCB2),
Providing (S3) a main PCB (PCB3),
Populating (S4) the main PCB (PCB3) and applying solder paste to the main PCB (PCB3),
Applying (S5) at least two glue dots to a surface of the interposer PCB (PCB2),
Providing (S6) a base component by soldering and gluing the interposer PCB (PCB2) on top of the main PCB (PCB3),
Applying (S7) solder paste to the interposer PCB (PCB2) of the base component,
Applying (S8) at least two glue dots to the antenna component,
Providing (S9) the multiband patch antenna by soldering and gluing the base component to the antenna component.
